# EUROPEAN PATENT APPLICATION

(11) **EP 4 793 952 A1**
(43) Date of publication of application: **19.08.2026**
(21) Application number: 26157765.4
(22) Date of filing: 11.02.2026
(51) Int. Cl.: G11C 29/12

(54) **TESTING SYSTEM FOR ELECTRONIC MEMORY DEVICES**

(30) Priority: 13.02.2025 IT 202500002802
(71) Applicant: NPLUST S.r.l., 05026 Montecastrilli (TR) (IT)
(72) Inventor: CAMPANELLI, Nicola, I-05026 Montecastrilli (TR) (IT); FERIANI, Alessandro, I-05026 Montecastrilli (TR) (IT); KEREKES, Tamas, I-05026 Montecastrilli (TR) (IT)
(74) Representative: Marchi, Davide

(57) **Abstract**

Test system (**200**) for testing electronic memory devices to be tested, wherein an electronic memory device (**105**) to be tested comprises a plurality of memory cells (**110**) arranged in a two-dimensional matrix arrangement comprising a plurality of matrix rows (**115**) and a plurality of matrix columns (**120**), each cell being electrically coupled to a respective electrically conductive row line (**R₁**, **R₂**, ..., **Rₙ**), to a respective first electrically conductive column line (**C₁₋₁**, **C₂₋₁**, ..., **Cₘ₋₁**) and to a respective second electrically conductive column line (**C₁₋₂, C₂₋₂,** ..., **Cₘ₋₂**), the electrically conductive row lines (**R₁**, **R₂**, ..., **Rₙ**), the first electrically conductive column lines (**C₁₁**, **C₂₋₁**, ..., **Cₘ₋₁**) and the second electrically conductive column lines (**C₁₋₂**, **C₂₋₂**, ..., **Cₘ₋₂**) of the electronic memory device (**105**) to be tested being directly accessible from outside the electronic memory device (**105**) itself. The test system (**200**) is configured to interface with the electronic memory device (**105**) to be tested for the execution of test operations of the electronic memory device (**105**) to be tested. The test system (**200**) comprises a row multiplexer (**305**), a first column multiplexer (**310**) and a second column multiplexer (**315**). The row multiplexer (**305**) is configured to interface with the electrically conductive row lines (**R₁**, **R₂**, ..., **Rₙ**) of the electronic memory device (**105**) to be tested, to select the electrical potential that is to be applied to the electrically conductive row lines (**R₁**, **R₂**, ..., **Rₙ**). The first column multiplexer (**310**) is configured to interface with all the first electrically conductive column lines (**C₁₋₁**, **C₂₋₁**, ..., **Cₘ₋₁**) of the electronic memory device (**105**) to be tested, and to select the electrical signal that is to be applied to each first electrically conductive column line (**C₁₋₁**, **C₂₋₁**, ..., **C ₘ₋₁**), The second column multiplexer (**315**) is configured to interface with all second electrically conductive column lines (**C₁₋₂**, **C₂₋₂**, ..., **Cₘ₋₂**) of the electronic memory device (**105**) to be tested, to select the electrical signal that is to be applied to each second electrically conductive column line (**C₁₋₂, C₂₋₂,** ..., **Cₘ₋₂**). The test system (**200**) is particularly suited to testing neuromorphic memories.

## Description

### Technical field of the invention

The present invention relates to the technical field of electronics, and more specifically it relates to a system for testing electronic memory devices, such as non-volatile memory devices.

The test system according to the present invention is particularly suitable for testing so-called neuromorphic memories, as well as for testing memories with so-called "crossbar" architecture which, like some neuromorphic memories, belong to the family of PCM, ReRAM or other technologies in which the electrical conductance of a memory element can be regulated in a controlled manner.

More generally, the test system according to the present invention is suitable for, and can be advantageously used for, testing memory devices in which there no address decoders are provided internally to the memory devices themselves for addressing and selecting individual, single (or individual, single groups of) row lines and column lines, and (all) the row lines and column lines are directly accessible from outside the memory device, such as for example in "test chips" or "test arrays" of memory devices.

### Overview of the relevant state of the art

In recent times we have witnessed, and continue to witness, a notable diffusion of Artificial Intelligence (AI) and its applications in various fields.

As industry experts know, the computing operations performed by AI-based systems are extremely computationally intensive (the amount of data to be processed and the amount of data processing operations themselves), and consequently the resource consumption (for example, electricity) involved is extremely high.

Nowadays, most of the operations performed by AI-based systems are performed in large data centers, where large resources, especially energy, are made available.

On the other hand, the computing model known as "edge computing" (translatable as "processing at the edge"), a distributed computing model in which data processing occurs as close as possible to where the data is generated and/or resides, particularly implemented on battery-powered devices, such as mobile communication devices ("smartphones") and so-called "wearable" devices (devices that the user can wear, such as "smart watches", "smart glasses" and "smart rings" - compact electronic devices designed to fit on a finger like a traditional jewelry ring) cannot rely on the availability of such large energy resources, and therefore requires the use of different solutions.

A possible alternative solution is based on an architecture called "in-storage computing" or "in-storage processing," also known as "in-situ processing" or "neuromorphic computing". Essentially, this is a technique in which data is processed where it resides (for example, in the data memories of smartphones, smart watches, smart glasses, or smart rings). Unlike more traditional architectures based on the Von Neumann model (the von Neumann architecture, which represents a simplified model of a computer, includes a part, called the processor, dedicated to data processing - for example, the execution of arithmetic and logical operations on data - and a part dedicated to data storage, called central memory; the central memory contains both the data on which the processor operates and the programs that provide the instructions to be carried out by the processor), in "in-storage computing" architectures the calculations are performed directly within the data memory, where the data to be processed resides, and in the analog domain rather than the digital one.

In applications based on in-storage computing architecture, a memory array (a structure in which a plurality of data storage cells, or memory cells, are arranged in a matrix-like arrangement, for example two-dimensional, by rows and columns), specifically a non-volatile memory (a type of data memory that retains information even when it is not supplied with power), is used to perform arithmetic operations such as vector multiplication. In such operations, one of the operation's operands, representing the "knowledge", is stored in the non-volatile memory, and the other operand of the operation is represented by the electrical potentials (voltages) applied to the rows of the memory array. The result of the operation is represented by the measurement of the current flowing in the columns of the memory array, according to Kirchhoff s law. Such memory matrices are also called "neuromorphic memory arrays" or, shortly, "neuromorphic arrays" or even "neuromorphic memories".

Hundreds of these interconnected neuromorphic memory arrays implement complex computational circuitry operating in the analog domain.

The enabling technology for realizing such neuromorphic memory arrays lies in some emerging types of memory, mainly RRAM (or ReRAM , "Resistive Random Access Memory") and PCM (" Phase Change Memory"). In these memories, information is stored by modifying the electrical conductance, or, dually, the electrical resistance, of the memory cells through electrical operations (known in jargon as "SET" and "RESET"). The memory cells of these memories are also called "memristors" ( memristors in Anglo-Saxon jargon). Considering PCM memories, for example, the SET operation allows the memory cell to be programmed into a state of (relatively) low electrical resistance (or, dually, of relatively high electrical conductance), while the RESET operation determines an increase in the electrical resistance (or, dually, a decrease in the electrical conductance) of the memory cell. Similar considerations apply to RRAM memories.

Neuromorphic computing is a viable alternative to traditional digital computing architectures based on the von Neumann model; it provides particular advantages in applications based on the " edge computing" model, where, as previously mentioned, low energy consumption is essential.

In general, during the development of a new electronic device, such as a new memory device, designed using a new manufacturing technology (e.g., a new photolithographic process involving a higher integration scale) and/or a new architecture, a statistically significant number of replicas of that device must be extensively and thoroughly tested using dedicated test systems during the development phase of the new technology/architecture before the device can be put into production and marketed. At least some of these testing procedures are typically performed on versions of the memory device (so-called "test chips") that can be manufactured in less time and at a lower cost than the final version of the product, and which at the same time allow the test system to perform more precise measurements.

Compared to traditional, "standard" memories (i.e., non-neuromorphic memories, designed for storing and retrieving digital data in traditional system architectures based on the von Neumann model), testing neuromorphic memory arrays poses specific challenges for technology developers. Traditional testing methods, used for traditional memory arrays, cannot be used due to the different memory architecture. For example, in the test chips (integrated circuit dies produced for the purposes of testing and validating the new technology and/or the new architecture during their development phase) of neuromorphic memory devices, there are no addressing signal decoders inside the memory device to be tested (so-called "test matrix" or "test memory array" or "test array") for the addressing and selection of single (or single groups of) row lines and column lines: in neuromorphic memories, the row lines and column lines of the memory cell array are directly accessible from outside the memory device itself.

Accuracy requirements are also higher than for standard memories, due to the need to store analog values rather than binary data.

### Summary of the invention

The Applicant noted that testing of neuromorphic memory arrays should focus on characteristics similar to those of standard non-volatile (i.e., non-neuromorphic) memories, and in particular on:
- non-volatility: the information content stored in the memories must remain stored even in the absence of an electrical power supply;
- reduced energy requirements;
- the speed of operation, both in the programming (writing) phase of the resistance values of the memory cells (memristors) and in the execution phase of the calculation operations;
- the retention of stored data: the information content stored in the memory shall be able to remain stored even for very long periods without loss of information ;
- sensitivity to disturbances ("disturb sensitivity"): operations on the memory cells shall not alter the data stored in those memory cells and in memory cells topologically close to them in the memory array;
- duration over time ("endurance"): the ability to continue to operate correctly even after a high number of writing (and reading) operations of the memory cells.

The Applicant further observed that, compared to standard non-volatile memories, neuromorphic memories pose specific requirements for their testing.

For example, the "test chips" or "test arrays" of memory cell arrays in neuromorphic memories have a large number of terminals, much greater than those in standard memories: while standard memory arrays operate on (relatively) few memory cells at a time (e.g., memory words, or memory pages), selected by memory address signal decoders internal to the standard memories, such memory address signal decoders are not present in neuromorphic arrays, in which all rows and columns of the array are used to perform computational operations.

Furthermore, the required accuracy is higher than that of standard memory arrays: the memory cells of neuromorphic arrays store analog values that can be represented by a certain number of bits (e.g. 4, 8 or even 12 bits, corresponding to 2⁴, 2⁸ or even 2¹² possible different values of electrical conductance), significantly higher than the number of bits per cell (1, 2 or 3 bits per cell) that can be stored by the memory cells of standard memory arrays.

Furthermore, drift sensitivity is higher in neuromorphic arrays than in standard memory arrays: as a consequence of the more stringent accuracy requirement, the electrical conductance values of the memristors that constitute the memory cells of neuromorphic memories should not change (or should change as little as possible) over time, and/or due to temperature variations and/or to disturbance effects.

The Applicant noted that known test methodologies are generally capable of operating at the level of individual memory cells, and when only one or a few bits of information are stored in the memory cells. Detailed measurements can provide information about individual cell characteristics, from which insights into how individual memory cells operate within a memory array can be derived. However, known test methodologies are unsatisfactory when greater precision is required (because the memory cells are intended to store data that translates to many bits per cell, as in neuromorphic devices).

In light of the above, the Applicant has addressed the problem of developing a system for the analysis, verification and testing of memory devices such as neuromorphic memories and, more generally, memory devices in which the row lines and column lines of the memory cell matrix are directly accessible from outside the memory device itself, since no addressing signal decoders are provided internally to the memory device for the addressing and selection of single (or single groups of) row lines and column lines, such a system being usable in particular (but not exclusively) in the early stages of development and fine-tuning of a new manufacturing technology for such memories, for testing the related "test chips" or "test arrays".

In accordance with one aspect of the present invention, a test system is provided for testing electronic memory devices to be tested.

The test system is designed to test an electronic memory device to be tested that comprises a plurality of memory cells arranged in a two-dimensional matrix arrangement comprising a plurality of matrix rows and a plurality of matrix columns, each memory cell being electrically coupled to a respective electrically conductive row line, a respective first electrically conductive column line, and a respective second electrically conductive column line; the electrically conductive row lines, the first electrically conductive column lines, and the second electrically conductive column lines of the electronic memory device to be tested are directly accessible from outside the electronic memory device to be tested.

The test system is configured to interface with the electronic memory device to be tested to perform test operations on the electronic memory device to be tested.

The test system comprises a row multiplexer, a first column multiplexer and a second column multiplexer.

The row multiplexer of the test system is configured to interface with the electrically conductive row lines directly accessible from the outside of the electronic memory device to be tested, to select the electrical potential to be applied to the electrically conductive row lines.

The first column multiplexer of the test system is configured to interface with the first electrically conductive column lines directly accessible from the outside of the electronic memory device to be tested, and to select the electrical signal to be applied to each first electrically conductive column line.

The second column multiplexer of the test system is configured to interface with the second electrically conductive column lines directly accessible from the outside of the electronic memory device to be tested, to select the electrical signal to be applied to each second electrically conductive column line.

In particular, all the electrically conductive row lines of the electronic memory device to be tested may be directly accessible from outside the memory device itself, and the row multiplexer of the test system may be configured to interface with all the electrically conductive row lines of the electronic memory device to be tested. All the first electrically conductive column lines of the electronic memory device to be tested may be directly accessible from outside the electronic memory device itself, and the first column multiplexer of the test system may be configured to interface with all the first electrically conductive column lines of the electronic memory device to be tested. All the second electrically conductive column lines of the electronic memory device to be tested may be directly accessible from outside the electronic memory device itself, and the second column multiplexer of the test system is configured to interface with all the second electrically conductive column lines of the electronic memory device to be tested.

In one possible embodiment of the present invention, the row multiplexer is configured to, and, when the test system is interfaced to the electronic memory device to be tested, it is operable to, maintain one or more electrically conductive row lines of the electronic memory device to be tested disconnected, or to selectively and independently route to each electrically conductive row line of the electronic memory device to be tested, an electrical signal selected from:
o a row electric potential waveform, common for all the electrically conductive row lines of the electronic memory device to be tested;
o a common reference electrical potential,
o a respective row reference electric potential independent for each electrically conductive row line.

In one possible embodiment of the present invention, the first column multiplexer is configured to, and, when the test system is interfaced to the electronic memory device to be tested, is operable to maintain one or more first electrically conductive column lines of the electronic memory device to be tested disconnected, or to selectively and independently route to each first electrically conductive column line of the electronic memory device to be tested, an electrical signal selected from:
o a first column electric potential waveform, common for all the first electrically conductive column lines of the electronic memory device to be tested;
o the common reference electric potential.

In one possible embodiment of the present invention, the second column multiplexer is configured to, and, when the test system is interfaced to the electronic memory device to be tested, is operable to keep one or more second electrically conductive column lines of the electronic memory device to be tested disconnected, or to electrically connect one or more second electrically conductive column lines of the electronic memory device to be tested to electrical quantities measurement devices, or to selectively and independently route to each second electrically conductive column line of the electronic memory device to be tested, an electrical signal selected from:
o a second column electric potential waveform, common for all the second electrically conductive column lines of the electronic memory device to be tested;
o the common reference electric potential.

In one possible embodiment of the present invention, the test system comprises one or more electrical quantities waveform generators, configured and operable to generate said row electric potential waveform, said first column electric potential waveform and said second column electric potential waveform.

In one possible embodiment of the present invention, the test system comprises reference electrical potential generators, configured and operable to generate said row reference electrical potential independently for each electrically conductive row line.

In a possible embodiment of the present invention, said electrical quantities measuring devices may comprise one or more current sensors, configured and operable to detect a current flowing in one or more of said second electrically conductive column lines of the electronic memory device to be tested, which, through the second column multiplexer, is/are connected to the electrical quantities measuring devices.

In particular, the row multiplexer may comprise a number of row multiplexer devices equal to the number of electrically conductive row lines of the electronic memory device to be tested, the row multiplexer devices being each interfaceable to a respective electrically conductive row line.

The first column multiplexer may comprise a number of first column multiplexer devices equal to the number of first electrically conductive column lines of the electronic memory device to be tested, the first column multiplexer devices each being interfaceable to a respective first electrically conductive column line of the electronic memory device to be tested.

The second column multiplexer may comprise a number of second column multiplexer devices equal to the number of second electrically conductive column lines of the electronic memory device to be tested, the second column multiplexer devices each being interfaceable to a respective second electrically conductive column line of the electronic memory device to be tested.

In particular, the test system can be configured to interface with and test a neuromorphic electronic memory device.

Advantageously, the test system is configured and operable to perform, on said electronic memory device to be tested:
- writing operations of single memory cells of the electronic memory device to be tested;
- reading operations of single memory cells of the electronic memory device to be tested;
- memory cell aging simulation operations;
- emulation operations of computational operations, particularly matrix multiplication operations, that the electronic memory device is intended to perform in use.

The test system according to the present invention is capable of operating on neuromorphic memories which, as explained above, comprise arrays of memory cells having a specific structure, different from that of ordinary arrays of data memory cells (for example, due to the fact that neuromorphic memories are intended to store analog values, have a high number of terminals, much greater than standard memories, and use all the rows and columns of the matrix to perform the calculation operations).

Advantageously, the test system according to the present invention can be configured to operate with neuromorphic arrays of different sizes.

The test system according to the present invention is able to rapidly perform "aging" operations which involve the execution of numerous SET and RESET operations on all the memory cells, thus being able to test the "endurance" of the neuromorphic arrays in reasonable times.

The test system according to the present invention is capable of subjecting the neuromorphic arrays to be tested to various stress conditions, useful for understanding the effects of the same on the neuromorphic arrays.

The test system according to the present invention is also capable of emulating the computational operations that neuromorphic arrays are intended to perform in their use, to analyze the behavior of neuromorphic arrays in an application-like environment.

The test system according to the present invention is capable of measuring the resistance/conductance of a single memristor cell with the necessary accuracy.

### Brief description of the drawings

The features and advantages of the present invention will become more apparent from reading the following detailed description of its exemplary and nonlimiting embodiments. For better understanding, the following description should be read with reference to the attached figures, in which:
**Fig. 1** shows schematically, in an extremely simplified way, the structure of (a small portion of) an array of neuromorphic memory cells, or neuromorphic array;
**Fig. 2** illustrates, at the level of the main functional blocks, the structure of a test system in accordance with an exemplary embodiment of the present invention, particularly suitable for testing a neuromorphic array of the type shown in **Fig. 1** ;
**Fig. 3** shows in more detail the structure of a subsystem of the test system of **Fig. 2****,** for interfacing with a neuromorphic array to be tested, in accordance with an exemplary embodiment of the present invention;
**Fig. 4** shows in more detail the structure of a first neuromorphic array column multiplexer, or top column multiplexer, of the interfacing subsystem of **Fig. 3****,** in accordance with an exemplary embodiment of the present invention;
**Fig. 5** shows in more detail the structure of a second neuromorphic array column multiplexer, or bottom column multiplexer, of the interfacing subsystem of **Fig. 3****,** in accordance with an exemplary embodiment of the present invention, and
**Fig. 6** shows in more detail the structure of a neuromorphic array row multiplexer of the interfacing subsystem of **Fig. 3****,** in accordance with an exemplary embodiment of the present invention.

### Detailed description of exemplary embodiments of the invention

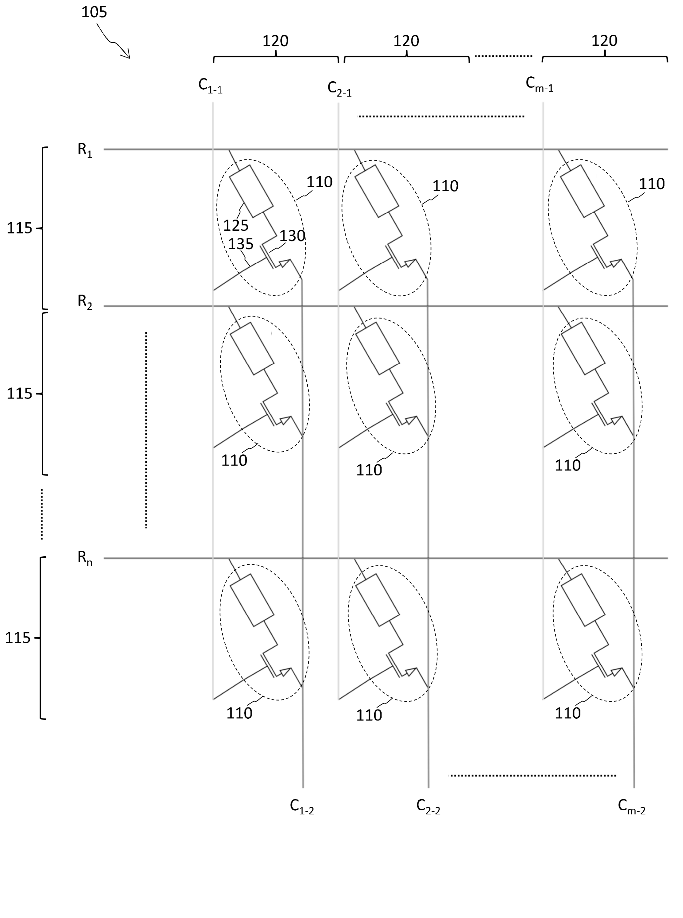

With reference to the figures, **Fig. 1** schematically shows, in an extremely simplified way, the structure of a neuromorphic memory cell array (or, more precisely, the structure of a small portion of a neuromorphic memory cell array) **105** (briefly, neuromorphic memory array or neuromorphic memory). The neuromorphic memory array **105** is, for example, integrated into a "test chip" that is produced, for testing and validation purposes, during the development phases of a new technology and/or a new architecture.

The neuromorphic array **105** comprises a plurality of memory cells (schematized by dashed ellipses) **110.**

The memory cells **110** are arranged in a two-dimensional arrangement according to a plurality of rows (neuromorphic memory array rows, or memory array rows, for brevity) and a plurality of columns (neuromorphic memory array columns, or memory array columns, for brevity).

The example shown in **Fig. 1** is intended to represent a (portion of a) neuromorphic array **105** comprising *n* memory array rows **115** and *m* memory array columns **120** (for simplicity, in **Fig. 1** three memory array rows **115** are physically drawn, with the symbol "....." representing the intermediate memory array rows that are not physically drawn; similarly, in **Fig. 1** three memory array columns **120** are physically drawn, with the symbol "....." representing the intermediate memory array columns that are not physically drawn; in practical cases, the neuromorphic array can be an array of order 3x3 (comprising 3 memory array rows and 3 memory array columns) or of higher order (for example of order 128x128 )).

The memory cells **110** are in particular arranged at the crossing or intersection points between the rows of the memory array **115** and the columns of the memory array **120.** In particular, each memory cell **110** is arranged at the intersection between a respective row of the memory array **115** and a respective column of the memory array **120;** only one respective memory cell **110** is arranged at the generic intersection between a row of the memory array **115** and a column of the memory array **120.**

Each row of the memory array **115** comprises an electrically conductive row line, or row line for short, such as the row lines **R ₁ , R ₂**, ..., **R ₙ** shown in **Fig. 1****.** Each column of the memory array **120** comprises a pair of electrically conductive column lines, or column lines for short, where the generic pair of column lines of a generic column of the memory array **120** comprises a first electrically conductive column line and a second electrically conductive column line (first and second column lines), such as the pairs of first and second column lines **C₁₋₁** and **C₁₋₂, C₂₋₁** and **C₂₋₂** , ..., **Cₘ₋₁** and **Cₘ₋₂** shown in **Fig. 1****.**

The generic memory cell **110** is electrically connected to a respective row line **R₁, R₂,** ..., **Rₙ** of the respective memory array row **115** and to a respective pair of first and second column lines **C₁₋₁** and **C₁₋₂, C₂₋₁** and **C₂₋₂**, ..., **Cₘ₋₁** and **Cₘ₋₂** of the respective memory array column **120.**

The generic memory cell **110** comprises an information storage element or memory element **125,** particularly of the "memristor" type, intended for data storage (the stored data being represented in terms of electrical conductance, or electrical resistance, of the memory element **125**), and a selector device **130** configured and operable for the selective access to the memory element **125.**

The memory element **125** may, for example, be or comprise a PCM ("Phase Change Memory") memory element, or an RRAM (or "ReRAM") memory element, or a memory element in any other technology that allows the electrical conductance of a memory element (memristor) to be adjusted in a controlled manner. The selector device **130** may, for example, be or comprise a digital switch, for example a transistor, in particular a field-effect transistor ("FET"), even more particularly, but not limited to, a field-effect transistor of the metal-oxide-semiconductor ("MOSFET") type.

In the generic memory cell **110,** the memory element **125** comprises a first electrical terminal electrically coupled or connected to the respective row line **R₁, R₂,** ..., **Rₙ** of the respective memory array row **115,** and a second electrical terminal electrically coupled or connected to a first electrical terminal of the selector device **130.** The selector device **130** comprises a second electrical terminal electrically coupled or connected to the respective second column line **C₁₋₂, C₂₋₂**, ..., **Cₘ₋₂** of the respective memory array column **120.** The selector device **130** comprises a control electrical terminal **135** electrically coupled or connected to the respective first column line **C₁₋₁, C₂₋₁,** ..., **Cₘ₋₁** of the respective memory array column **120** .

In use, by applying a suitable electric potential (voltage) to the generic first column line **C₁₋₁, C₂₋₁,** ..., **Cₘ₋₁** of the generic memory array column **120,** the selector devices **130** of (all) the memory cells **110** of that memory array column **120** are turned on (i.e., made electrically conductive), so as to establish electrically conductive paths, passing through the memory elements **125** of the memory cells **110** of that memory column **120,** between the row lines **R₁, R₂,** ..., **Rₙ** and the second column lines **C₁₋₂, C₂₋₂**, ..., **Cₘ₋₂.**

From **Fig. 1** and its description it is possible to see the profound differences between a memory cell array of a neuromorphic memory and a "standard", non-neuromorphic memory cell array: for example, in the neuromorphic array the row lines are connected to the (first) electrical terminal of the memory element, not to the control terminals of the selector devices **130** as is instead the case in a "standard" memory array, and the control terminals of the selector devices **130** are connected to respective first column lines, rather than to respective row lines as is instead the case in a "standard" memory array. Furthermore, internally to a "test chip" or "test array" of a neuromorphic memory there are no addressing signal decoders (unlike in standard memories) for addressing and selecting single (or single groups of) row lines and column lines: in a neuromorphic memory (all) row lines and column lines of the memory cell array are directly accessible from outside the memory device itself.

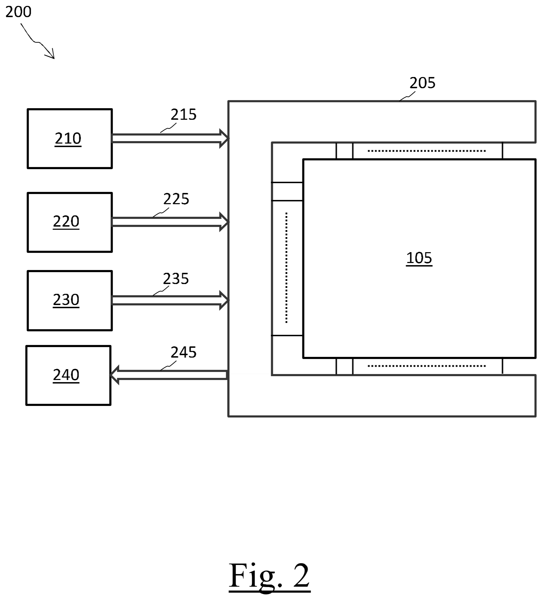

**Fig. 2** illustrates, at the level of the main functional blocks or modules, the structure of a test system **200** in accordance with an exemplary embodiment of the present invention, particularly suitable for testing a memory cell array, in particular suitable for testing a memory cell array with a neuromorphic matrix-type structure, such as a memory array of the type shown in **Fig. 1** and described above (the neuromorphic array **105**), or, more generally, suitable for testing memory devices in which no address decoders are provided internally to the memory devices themselves for addressing and selecting individual, single (or individual, single groups of) row lines and column lines, and in which the row lines and column lines are directly accessible from outside the memory device.

The test system **200** includes a subsystem **205** for interfacing with the memory array to be tested, such as the neuromorphic array **105.**

The test system **200** comprises one or more electrical quantities waveform generators **210,** configured and operable to generate electrical quantities waveforms **215,** for example of electric potential (electrical voltage), to be supplied to the interfacing subsystem **205.** The electrical quantities waveforms **215** generated by the waveform generators **210** represent stimuli that the interfacing subsystem **205** supplies to the neuromorphic array **105** during the various testing operations of the latter. For example, the electrical quantities waveforms **215** comprise electrical quantities waveforms (for example, voltage pulses) to be supplied to the neuromorphic array **105** for the execution of write operations ("SET" and "RESET") of the memory cells **110** of the neuromorphic array **105,** i.e., operations aimed at modifying the electrical conductance of the memory cells **110.**

The test system **200** also includes one or more control signals generators **220,** configured and operable to generate control signals **225** to be supplied to the interfacing subsystem **205** to control its operation during the various testing operations of the neuromorphic array **105.**

The test system **200** further comprises one or more reference electrical potential (voltage) generators **230,** configured and operable to generate reference voltages **235,** in particular stable, non-variable voltages, to be supplied to the interfacing subsystem **205.**

The test system **200** also comprises devices for measuring electrical quantities **240,** for example electrical current meters, to measure electrical quantities (currents) **245** supplied by the neuromorphic array **105** in response to the stimuli received during its testing, and collected, detected by the test system **200.**

The test system **200** may comprise further modules (not shown as they are not relevant for the understanding of the embodiments of the present invention described herein), for example to supervise the operations performed by the waveforms generators **205,** the control signals generators **220,** the measuring devices **230.** For example, the test system **200** may be part of a more complex electronic device testing equipment or apparatus, equipped with its own processing and control units and human-machine interfaces.

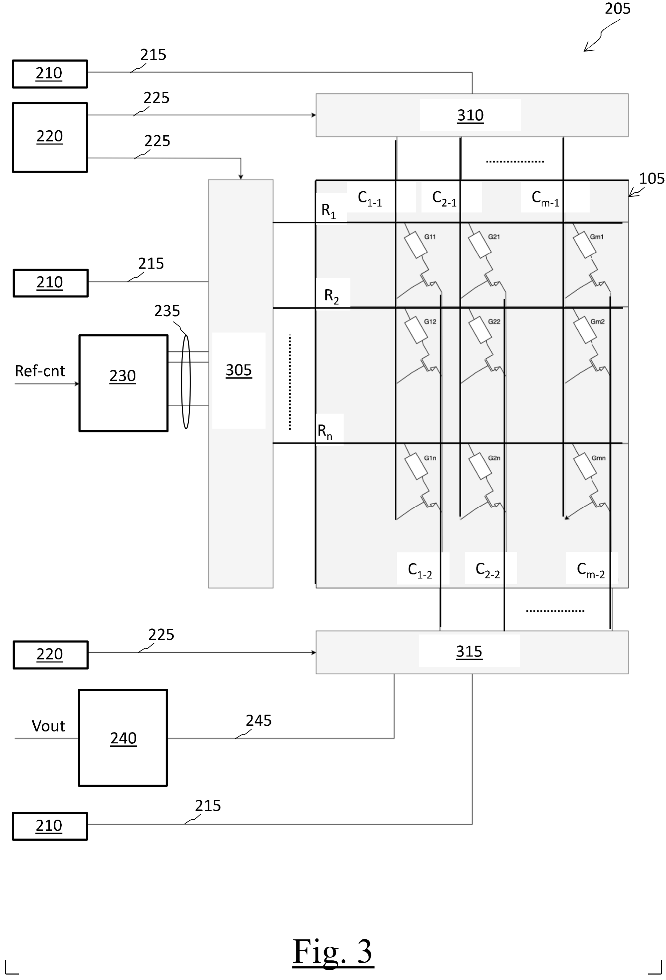

**Fig. 3** shows in more detail the structure of the interface subsystem **205** of the test system **200,** in accordance with an exemplary embodiment of the present invention.

The interfacing subsystem **205** comprises a row line multiplexer (row multiplexer) **305,** a first column line multiplexer **310,** or top column multiplexer, and a second column line multiplexer **315,** or bottom column multiplexer.

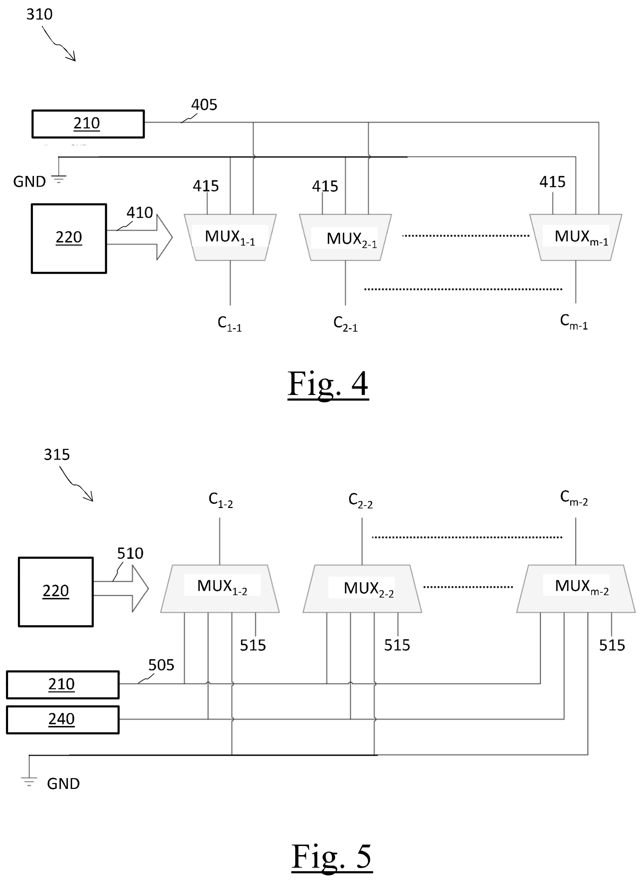

The top column multiplexer **310** is configured and operable in a configurable manner, by (a portion of) the control signals **225** generated and provided by the control signal generator(s) **220,** to select the electrical signal to be applied to each first column line **C₁₋₁, C₂₋₁, ..., Cₘ₋₁** of the memory array columns **120** of the neuromorphic array **105** to be tested. In particular, as shown schematically but in greater detail in **Fig. 4****,** the top column multiplexer **310** comprises as many top column multiplexer devices **MUX₁₋₁, MUX₂₋₁, ..., MUXₘ₋₁** as there are (*m* in the example considered) memory array columns **120** of the neuromorphic array **105** (a top column multiplexer device for each memory array column **120** of the neuromorphic array **105**).

The top column multiplexer **310** is configurable to route, supply, selectively and independently, to each first column line **C₁₋₁, C₂₋₁, ..., Cₘ₋₁** of the memory array columns **120** (and therefore, independently for each memory array column **120** of the neuromorphic array **105,** to the electrical control terminals **135** of the selector devices **130** of all the memory cells **110** of that memory array column **120**), an electrical signal selected from:
- an electric potential waveform **405,** part of the electric quantities waveforms **215,** common for all the first column lines **C₁₋₁, C₂₋₁, ..., Cₘ₋₁** of the memory columns **120;**
- a common reference electrical potential **GND** (ground),
or to maintain one or more first column lines **C₁₋₁, C₂₋₁,** ..., **Cₘ₋₁** of the memory array columns **120** disconnected, floating, in a high impedance condition (condition indicated by **415** in **Fig. 4**).

The selection of which electrical signal to supply to the generic first column line **C₁₋₁, C₂₋₁,** ..., **Cₘ₋₁,** between the electrical potential waveform **405** and the common reference electrical potential **GND,** or whether to keep the generic first column line **C₁₋₁, C₂₋₁,** ..., **Cₘ₋₁** disconnected, floating (in high impedance condition) is performed by the respective top column multiplexer device **MUX₁₋₁, MUX₂₋₁, ..., MUXₘ₋₁** upon control of respective top column multiplexer control signals **410,** part of the control signals **225.** In particular, the control signals of the top column multiplexer **410** may be digital, logic signals and may comprise a pair of logic signals for each of the (*m*) top column multiplexer devices **MUX₁₋₁, MUX₂₋₁, ..., MUXₘ₋₁** (the pair of logic signals being sufficient to select, by means of the different combinations of logic values, one out of the three possible different states of the generic column top multiplexer device **MUX₁₋₁, MUX₂₋₁, ..., MUXₘ₋₁**).

Preferably, the top column multiplexer devices **MUX₁₋₁, MUX₂₋₁, ..., MUX**_{**m-**1} are implemented using analog switches/switches with low series resistance and wide bandwidth, in order to be able to perform state switching quickly and ensure the necessary quality in the transferred electrical signal.

The bottom column multiplexer **315** is structured and operable in a configurable manner, by (a part of) the control signals **225** generated and provided by the control signals generator(s) **220,** to select the electrical signal that is to be applied to each second column line **C₁₋₂, C₂₋₂**, **..., Cₘ₋₂** of the memory array columns **120** of the neuromorphic array **105,** or to electrically connect one or more of the second column lines **C₁₋₂**, **C₂₋₂**, ..., **Cₘ₋₂** to the electrical quantities measurement devices **240.** In particular, as shown schematically but in greater detail in **Fig. 5****,** the bottom column multiplexer **315** comprises as many bottom column multiplexer devices **MUX₁₋₂, MUX₂₋₂, ..., MUXₘ₋₂** as there are (*m* in the example considered) memory array columns **120** of the neuromorphic array **105** (one bottom column multiplexer device for each memory array column **120** of the neuromorphic array **105**).

The bottom column multiplexer **315** is configurable to route, supply, selectively and independently to each second column line **C₂₋₁, C₂₋₂**, **..., Cₘ₋₂** of the memory array columns **120** (and therefore, independently for each memory array column **120** of the neuromorphic array **105,** to the second electrical terminals of the selector devices **130** of all the memory cells **110** of that memory array column **120**), an electrical signal selected from:
- an electric potential waveform **505,** part of the electric quantities waveforms **215,** common for all the second column lines **C₁₋₂, C₂₋₂**, **..., Cₘ₋₂** of the memory array columns **120** ;
- the common reference electrical potential **GND** (ground or earth),
or to maintain one or more second column lines **C₁₋₂, C₂₋₂**, **..., Cₘ₋₂** of the memory array columns **120** disconnected, floating, in a high impedance condition (condition indicated by **515** in **Fig. 5**).

Furthermore, the bottom column multiplexer **315** is configurable to selectively connect one of the second column lines **C₁₋₂, C₂₋₂**, **..., Cₘ₋₂** to the electrical quantities measuring devices **240.**

The configuration of the bottom column multiplexer **315,** and therefore of the various bottom column multiplexer devices **MUX₁₋₂, MUX₂₋₂, ..., MUXₘ₋₂** is carried out under control of respective bottom column multiplexer control signals **510,** part of the control signals **225.** In particular, the bottom column multiplexer control signals **510** can be digital, logic signals and includes a pair of logic signals for each of the (*m*) bottom column multiplexer devices **MUX₁₋₂, MUX₂₋₂, ..., MUXₘ₋₂** (the pair of logic signals being sufficient to select, by means of the different combinations of logic values, one out of the four possible different states of the generic bottom column multiplexer device **MUX₁₋₂, MUX₂₋₂, ..., MUXₘ₋₂**).

In the exemplary embodiment of the present invention considered and shown in **Fig. 5****,** to selectively connect one of the second column lines **C₁₋₂, C₂₋₂**, **..., Cₘ₋₂** to the electrical quantities measurement devices **240,** the various bottom column multiplexer devices **MUX₁₋₂, MUX₂₋₂, ..., MUXₘ₋₂** are configured (by means of the bottom column multiplexer control signals **510**) so that only one of the various bottom column multiplexer devices **MUX₁₋₂, MUX₂₋₂, ..., MUXₘ₋₂** at a time connects the respective second column line **C₁₋₂, C₂₋₂**, **..., Cₘ₋₂** to the electrical quantities measurement devices **240.** In this case, the electrical quantity (current) measurable by the electrical quantity measuring devices **240** corresponds to the current flowing in that second column line **C₁₋₂, C₂₋₂**, **..., Cₘ₋₂** which is connected (via the respective bottom column multiplexer device **MUX₁₋₂, MUX₂₋₂, ..., MUXₘ₋₂**) to the electrical quantities measuring devices **240.**

In embodiments of the present invention, the bottom column multiplexer **315** may be configured and operable to selectively connect to the electrical quantities measuring devices **240** more than one, for example groups of two or more second column lines **C₁₋₂, C₂₋₂**, **..., Cₘ₋₂**, or even all of the second column lines **C₁₋₂, C₂₋₂**, **..., Cₘ₋₂**. In such a case, the electrical quantities (current) measurable by the electrical quantity measurement devices **240** corresponds to the sum of the currents flowing in that group of second column lines **C₁₋₂, C₂₋₂**, **..., Cₘ₋₂** which are connected (via the respective bottom column multiplexer devices **MUX₁₋₂, MUX₂₋₂, ..., MUXₘ₋₂**) to the electrical quantities measuring devices **240.**

In exemplary embodiments of the present invention, the bottom column multiplexer **315** may include multiplexer blocks.

The electrical quantities measuring devices **240** may comprise a (single) measurement channel or multiple measurement channels, for example a number of measurement channels equal to the number (*m* in the example considered) of second column lines **C₁₋₂, C₂₋₂**, ..., **Cₘ₋₂** (and therefore a number of measurement channels equal to the number of memory array columns **120** of the neuromorphic array). The possibility of connecting to the electrical quantities measuring devices **240** more than one second column line **C₁₋₂, C₂₋₂**, **..., Cₘ₋₂** at a time (and at the same time the provision, in the electrical quantities measuring devices **240,** of more than one measurement channel, in particular if the different measurement channels are configured to be able to operate in parallel) improves the performance of the measuring system, reducing the time required for reading the test results.

Preferably, the bottom column multiplexer devices **MUX₁₋₂, MUX₂₋₂, ..., MUXₘ₋₂** are implemented using analog switches/switches with low series resistance, wide bandwidth and low leakage currents, in order to be able to perform state switching quickly and ensure the necessary quality in the transferred electrical signal.

The row multiplexer **305** is structured and operable to be configurable, by (a portion of) the control signals **225** generated and provided by the control signals generator(s) **220,** to select the electrical potential that is to be applied to the row lines **R₁, R₂,** ..., **Rₙ** of the neuromorphic array **105.**

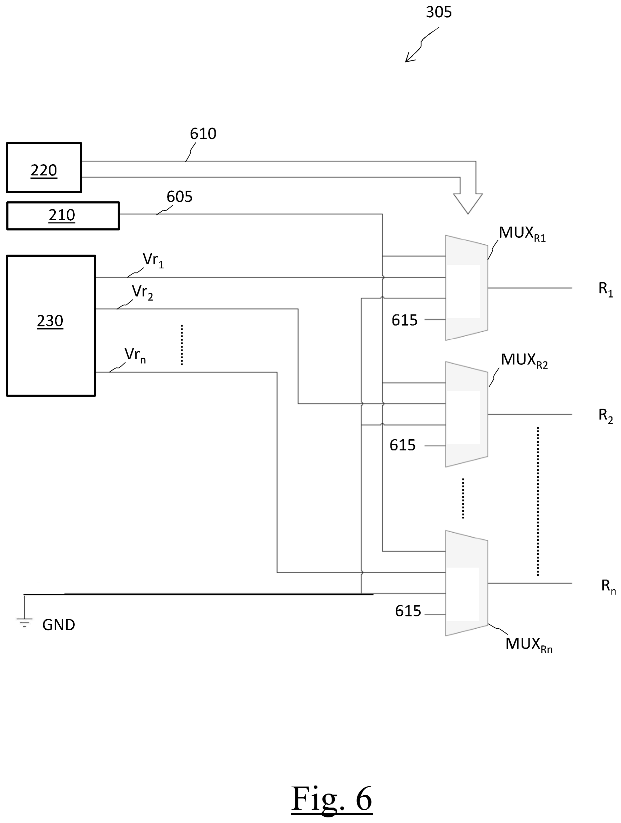

In particular, as shown schematically but in greater detail in **Fig. 6****,** the row multiplexer **305** comprises as many row multiplexer devices **MUX_{R1}**, **MUX_{R2}, ..., MUX_{Rn}** as there are (*n* in the example considered) memory array rows **115** of the neuromorphic array **105** (one row multiplexer device for each memory array row **115** of the neuromorphic array **105**).

The row multiplexer **305** is configurable to route, supply, selectively and independently to each row line **R₁, R₂, ..., Rₙ** of the neuromorphic array **105** (and therefore, independently for each memory array row **115** of the neuromorphic array **105,** to the first electrical terminals of the memory elements **125** of all the memory cells **110** of that memory array row **120**), an electrical signal selected from:
- an electric potential waveform **605,** part of the electric quantities waveforms **215,** common for all the row lines **R₁, R₂, ..., Rₙ** of the memory array rows **115;**
- the common reference electrical potential **GND** (ground or earth),
- a respective reference electric potential **Vr₁, Vr₂, ..., Vrₙ** (independent for each row line **R₁, R₂, ..., Rₙ**),
or to keep one or more row lines **R₁, R₂, ..., Rₙ** of the memory rows **115** disconnected, floating, in a high impedance condition (condition indicated by **615** in **Fig. 6**).

The configuration of the row multiplexer **305,** and hence of the various row multiplexer devices **MUX_{R1}, MUX_{R2}, ..., MUX_{Rn},** is carried out under the control of respective row multiplexer control signals **610,** part of the control signals **225.** In particular, the row multiplexer control signals **610** may be digital, logic signals and comprise a pair of logic signals for each of the (*n*) row multiplexer devices **MUX_{R1}**, **MUX_{R2}, ..., MUX_{Rn}** (the pair of logic signals being sufficient to select, by means of the different combinations of logic values, one out of the four possible different states of the generic row multiplexer device **MUX_{R1}**, **MUX_{R2}, ..., MUX_{Rn}).**

Preferably, the row multiplexer devices **MUX_{R1}**, **MUX_{R2}, ..., MUX_{Rn}** are implemented using analog switches/commutators with low series resistance and wide bandwidth, in order to be able to perform state switching quickly and ensure the necessary quality in the transferred electrical signal.

The one or more reference electrical potential (voltage) generators **230,** configured and operable to generate reference voltages **235** to be supplied to the interfacing subsystem **205,** comprise a number of reference voltage generators equal to the number (*n* in the example) of memory array rows **115** of the neuromorphic array **105.** Since in a real neuromorphic array the number of memory array rows **115** can be (and generally is) very high, the number of reference voltage generators is equally very high. These reference voltage generators are controlled by the test system **200** (or by the test equipment into which the test system **200** is inserted). For example, in embodiments of the present invention, the reference voltage sources may be controlled by control signals **Ref- cnt** (see **Fig. 3**) conforming to a communication protocol requiring a small number of signal lines, preferably a serial communication protocol such as a Serial Peripheral Interface ("SPI") protocol or an Inter- Integrated Circuit ("I²C"⁾ protocol.

The electrical quantities measuring devices **240** comprise, in an exemplary embodiment of the present invention, one or more current sensors, configured and operable to detect the current flowing in the second column line **C₁₋₂, C₂₋₂**, **..., Cₘ₋₂** which, through the column bottom multiplexer **315,** is coupledor connected to the electrical quantities measuring devices **240** (or, in embodiments of the present invention, to detect the sum of the currents flowing in the second column lines of the group of second column lines which, through the bottom column multiplexer **315,** is coupled to the electrical quantities measuring devices **240**). In exemplary embodiments of the present invention, the current sensor(s) may comprise a programmable voltage source, a current sensing circuit and a current/voltage converter. In embodiments of the present invention, the electrical measurement devices **240** provide an output electrical potential (voltage) **Vout** that corresponds to the current detected flowing in the second selected memory column, or in the second selected memory columns (and therefore to the conductance of the selected memory cell(s) **110**). Based on the value of the electrical potential **Vout** provided by the test system **200,** the test apparatus of which the test system **200** is a part can establish the outcome of the testing operation.

After having described the exemplary structure of the test system **200,** its operation will now be described, according to a preferred embodiment of the present invention. In particular, some of the testing operations that the test system **200** in accordance with the exemplary embodiment of the present invention described herein is able to perform on a generic neuromorphic matrix, such as the neuromorphic matrix **105** of **Fig. 1****,** will be described below.

### Operation of modifying the conductance of a single memory cell single memristor)

With reference to the figures, the operation of modifying the electrical conductance of a memory cell of the neuromorphic array comprises modifying the electrical conductance value of the memory element **125** (memristor) of a selected memory cell **110** of the neuromorphic array **105.** The operation of modifying the conductance of a memory cell is also called a "programming operation" (or "writing operation") of the memory cell (or of the memory element - memristor - of the memory cell).

The write operation involves applying SET and RESET electrical pulses to the first electrical terminal or the second electrical terminal of the memory element **125,** with consecutive read operations aimed at verifying whether the conductance value of the memory element **125** falls within a desired predetermined range of values. For example, the write operation involves iterating the application of one or more SET (or RESET) electrical pulses followed by a read operation to verify the conductance value, all iterated until the read operation confirms that the conductance value falls within the predetermined range of values.

In order to be able to program the memory element **125** of a selected memory cell **110,** the corresponding selector device **130** must be made electrically conductive (i.e., the selector device **130,** e.g., the MOSFET, must be "open"), in order to be able to (electrically) access the respective memory element **125.** For this purpose, the top column multiplexer **310** is configured to route an enable signal (in particular a relatively high static electrical potential - voltage - e.g. 1 or 2 Volts) to the first column line **C₁₋₁, C₂₋₁, ..., Cₘ₋₁** of the memory array column **120** to which the memory cell **110** to be programmed belongs, and which is connected to the control terminals of the selector devices **130** of all the memory cells of that memory array column **120.** The top column multiplexer **310** instead routes a disabling signal (for example the common reference electrical potential **GND**) to the first column lines **C₁₋₁, C₂₋₁, ..., Cₘ₋₁** of the other memory array columns **120,** so as to keep the selector devices **130** of the memory cells **110** of all the other columns of memory array **120** disabled (electrically nonconductive).

Through the row multiplexer **305,** the SET electrical pulse (the electric potential waveform **605,** part of the electric quantities waveforms **215,** generated by the waveforms generators **210**) is applied to the selected memory element **125** of the chosen memory cell **110** by generating an electric potential (voltage) pulse on the row lines **R₁, R₂, ..., Rₙ** of the memory array row **115** to which the chosen memory cell **110** belongs. The common reference potential **GND** is applied to the remaining row lines **R₁, R₂, ..., Rₙ** of the other memory array rows **115** of the neuromorphic array **105.**

Through the bottom column multiplexer **315,** a static electric potential (voltage) (for example a few Volts), or a voltage ramp, or the common reference potential **GND** is applied to the second column line **C₁₋₂, C₂₋₂**, **..., Cₘ₋₂** of the memory array column **120** to which the selected memory cell **110** belongs, depending on the technology with which the memory elements (memristors) **125** are made (e.g. PCM, RRAM,...), while the common reference potential **GND** is applied to the second column lines **C₁₋₂, C₂₋₂**, **..., Cₘ₋₂** of the remaining columns of memory array **120.**

The application of the RESET pulse is similar to the application of the SET pulse, with the difference that the roles of the row lines **R₁, R₂, ..., Rₙ** and the second column lines **C₁₋₂, C₂₋₂**, **..., Cₘ₋₂** are reversed with respect to the applied electric potentials.

The operation of reading (READ) the electrical conductance value of the memory element (memristor) **125** of the selected memory cell **110** requires the application (by means of the row multiplexer **305**) of an electrical potential (voltage) to the row line **R₁, R₂,** ..., **Rₙ** to which the first electrical terminal of the memory element **125** of that memory cell **110** is connected, and (by means of the electrical quantities measuring devices **240**) the measurement of the current flowing through the second column line **C₁₋₂, C₂₋₂**, **..., Cₘ₋₂** of the the memory matrix column **120** to which the selected memory cell **110** belongs. In order to be able to access in reading the memory element **125** of the selected memory cell **110,** the relevant selector device **130** shall be made electrically conductive (i.e., the selector device **130,** e.g., the MOSFET, must be "open"), in order to be able to (electrically) access the respective memory element **115.** To this end, the top column multiplexer **310** is configured to route the enable signal to the first column line **C₁₋₁, C₂₋₁, ..., Cₘ₋₁** of the memory array column **120** to which the memory cell **110** to be read belongs, and which is connected to the control terminals of the selector devices **130** of all the memory cells of that memory array column **120.** By means of the row multiplexer **305** and, respectively, the bottom column multiplexer **315,** the common reference potential GND is applied to the row lines **R₁, R₂, ..., Rₙ** of the remaining arrays rows **115** (to which the selected memory cell **110** does not belong) and to the second column lines **C₁₋₂, C₂₋₂**, ..., **Cₘ₋₂** of the other memory array columns **120,** or they are kept disconnected, in the high impedance condition.

### Cycling / aging operation

To emulate the inevitable aging phenomenon to which the memory elements (memristors) **125** of a neuromorphic array **105** will be subject in use, it is possible to perform a relatively high number of SET and RESET operations on the memory cells **110** of the neuromorphic array **105.** This process is also called "cycling". When performing the "cycling" procedure, it is not of particular interest to evaluate the accuracy of the programming operations of the memory cells **110** (i.e., it is not of particular interest to evaluate the accuracy of the electrical conductance values of the memristor memory elements **125** of the memory cells **110** achieved by performing the SET and RESET operations): therefore, it is possible to omit the READ operations of the electrical conductance values of the memristors **125** after each SET or RESET operation. This allows the "cycling" procedure to be speeded up.

To further speed up the "cycling" procedure, it is possible to perform the SET and/or RESET operations on more than one memory cell **110** at a time, for example on multiple memory cells **110** at a time. For example, the top column multiplexer **310** can enable the selector devices **130** of the memory cells **110** of more than one memory array column **120** at a time, and (by appropriately configuring the row multiplexer **305** and the bottom column multiplexer **315**) the electric potential pulses required to perform the SET and/or RESET operations can be applied to more than one row line **R₁, R₂, ..., Rₙ** and to more than one second column line **C₁₋₂, C₂₋₂**, **..., Cₘ₋₂** at a time.

### Calculation emulation operation

The test system **200** according to an embodiment of the present invention is configured and operable to emulate the execution of computational operations that a neuromorphic memory will be designed to perform in its use. For example, computational operations that the test system **200** can cause a neuromorphic memory to emulate include matrix multiplication.

To perform a computation operation, the memory cells **110** of a neuromorphic array **105** to be tested shall first be programmed (i.e., the electrical conductance values of the memory elements - memristors **- 125** of the memory cells **110** shall be set). The electrical conductance values to which the memristors **125** are programmed correspond to one of the operands of the computation operation (matrix multiplication) that is to be performed.

The top column multiplexer **310** is configured to enable all the selector devices **130** of all the memory cells **110** of all the memory array columns **120.** This is achieved by applying (through the top column multiplexer **310**) relatively high static electric potentials (voltages) (of the order of a few volts) to each of the first column lines **C₁₋₁, C₂₋₁, ..., Cₘ₋₁.**

The reference potential (voltage) generators **230** are programmed to generate reference potentials **Vr₁, Vr₂, ..., Vrₙ** corresponding to the other operand of the matrix multiplication operation to be performed. The row multiplexer **305** is configured to apply to each of the row lines **R₁, R₂, ..., Rₙ** of the memory array rows **115** the respective potential **Vr₁, Vr₂, ..., Vrₙ**.

The bottom column multiplexer **315** is controlled to couple the second column lines **C₁₋₂, C₂₋₂**, **..., Cₘ₋₂** to the electrical measuring devices **240,** for example, one at a time. For example, the bottom column multiplexer **315** is controlled to select the second column line **C₁₋₂, C₂₋₂**, **..., Cₘ₋₂** of the memory array column **120** whose current is to be measured, routing the current flowing through the selected second column line **C₁₋₂, C₂₋₂**, **..., Cₘ₋₂** to the current sensing circuit; all other second column lines **C₁₋₂, C₂₋₂**, **..., Cₘ₋₂** of the remaining array columns **120** are held at the common reference potential **GND.**

Once the current measurement of the second selected column line is made, the bottom column multiplexer **315** is controlled to select another second column line, e.g. the next second column line.

As mentioned above, it is also possible to measure the current flowing in more than one second column line at a time, for example by providing multi-channel electrical measuring devices capable of performing measurements in parallel.

### Disturbances

The test system **200** according to the exemplary embodiment of the present invention described herein, in particular the very flexibly configurable row **305,** top column **310** , and bottom column **315** multiplexers, enables the application of static and dynamic electrical potentials (voltages) in multiple configurations to a neuromorphic memory to be tested. Thanks to this, the test system **200** is able to implement operations for applying disturbances to a neuromorphic memory to be tested; such disturbances can advantageously be made specific for each specific technology with which the neuromorphic memory is implemented.

Although the present invention has been described with reference to the testing of neuromorphic memories, and in such an application the invention is particularly advantageous, this should not be construed as a limitation of the scope of applicability of the present invention. For example, the test system according to the present invention can also be advantageously used for testing other types of memory devices, for example memories with so-called "crossbar" architecture which, like some neuromorphic memories, belong to the family of PCM, ReRAM or other technologies in which the electrical conductance of a memory element can be regulated in a controlled manner; in crossbar memories (as in neuromorphic memories) there are no address decoders internal to the memory devices (for the addressing and selection of single (or single groups of) row lines and column lines), and all row lines and column lines are directly accessible from outside the memory device.

More generally, therefore, the test system according to the present invention can be advantageously used for testing all those memory devices in which all the row lines and column lines of the memory cell matrix are directly accessible from outside the memory device itself, since no addressing signal decoders are provided internally to the memory device for the addressing and selection of single (or single groups of) row lines and column lines, as occurs for example in "test chips" or "test arrays".

Naturally, a person skilled in the art may make numerous logical and/or physical modifications and alterations to the above-described solution. More specifically, although the present invention has been described with a certain degree of detail with reference to preferred embodiments thereof, it should be understood that various omissions, substitutions, and modifications in form and detail, as well as other embodiments, are possible. Specifically, various embodiments of the invention may also be practiced without the specific details reported in the preceding description to provide a deeper understanding thereof; conversely, known features may have been omitted or simplified to avoid burdening the description with unnecessary detail.

## Claims

1. Test system (**200**) for testing electronic memory devices to be tested, wherein an electronic memory device (**105**) to be tested comprises a plurality of memory cells (**110**) arranged in a two-dimensional matrix arrangement comprising a plurality of matrix rows (**115**) and a plurality of matrix columns (**120**), each memory cell (**110**) being electrically coupled to a respective electrically conductive row line (**R₁, R₂,** ..., **Rₙ**), to a respective first electrically conductive column line (**C₁₋₁, C₂₋₁,** ..., **Cₘ₋₁**) and to a respective second electrically conductive column line (**C₁₋₂, C₂₋₂**, ..., **Cₘ₋₂**), wherein the electrically conductive row lines (**R₁, R₂,** ..., **Rₙ**), the first electrically conductive column lines (**C₁₋₁, C₂₋₁,** ..., **Cₘ₋₁**) and the second electrically conductive column lines (**C₁₋₂**, **C₂₋₂**, **..., Cₘ₋₂**) of the electronic memory device (**105**) to be tested are directly accessible from outside the electronic memory device (**105**) to be tested itself,
wherein the test system (**200**) is configured to interface with the electronic memory device (**105**) to be tested for performing test operations on the electronic memory device (**105**) to be tested,
the test system (**200**) comprising a row multiplexer (**305**), a first column multiplexer (**310**) and a second column multiplexer (**315**),
wherein:
- the row multiplexer (**305**) is configured to interface with the electrically conductive row lines (**R₁, R₂,** ..., **Rₙ**) directly accessible from outside of the electronic memory device (**105**) to be tested, and to select the electrical potential that is to be applied to the electrically conductive row lines (**R₁, R₂,** ..., **Rₙ**);
- the first column multiplexer (**310**) is configured to interface with the first electrically conductive column lines (**C₁₋₁, C₂₋₁,** ..., **Cₘ₋₁**) directly accessible from outside of the electronic memory device (**105**) to be tested, and to select the electrical signal that is to be applied to each first electrically conductive column line (**C₁₋₁, C₂₋₁,** ..., **Cₘ₋₁**), and
- the second column multiplexer (**315**) is configured to interface with the second electrically conductive column lines (**C₁₋₂, C₂₋₂**, **..., Cₘ₋₂**) directly accessible from outside of the electronic memory device (**105**) to be tested, and to select the electrical signal that is to be applied to each second electrically conductive column line (**C₁₋₂, C₂₋₂**, ..., **Cₘ₋₂**).

2. Test system ( **200** ) according to claim 1, wherein:
- the row multiplexer (**305**) is configured to, and, when the test system (**200**) is interfaced to the electronic memory device (**105**) to be tested, is operable to keep one or more electrically conductive row lines (**R₁, R₂,** ..., **Rₙ**) of the electronic memory device (**105**) to be tested electrically disconnected, or to route, selectively and independently, to each electrically conductive row line (**R₁, R₂,** ..., **Rₙ**) of the electronic memory device (**105**) to be tested, an electrical signal selected from:
o a row electric potential waveform (**605**), common to all the electrically conductive row lines (**R₁, R₂,** ..., **Rₙ**) of the electronic memory device (**105**) to be tested;
o a common reference electrical potential (**GND**),
o a respective row reference electric potential (**Vr₁, Vr₂, ..., Vrₙ**) independent for each electrically conductive row line (**R₁, R₂, ..., Rₙ**),
- the first column multiplexer (**310**) is configured to, and, when the test system (**200**) is interfaced to the electronic memory device (**105**) to be tested, is operable to keep one or more first electrically conductive column lines (**C₁₋₁, C₂₋₁,** ..., **Cₘ₋₁**) of the electronic memory device (**105**) to be tested electrically disconnected, or to route, selectively and independently, to each first electrically conductive column line (**C₁₋₁, C₂₋₁, ..., Cₘ₋₁**) of the electronic memory device (**105**) to be tested, an electrical signal selected from:
o a first column electric potential waveform (**405**), common for all the first electrically conductive column lines (**C₁₋₁, C₂₋₁,** ..., **Cₘ₋₁**) of the electronic memory device (**105**) to be tested;
o the common reference electrical potential (**GND**),
- the second column multiplexer (**315**) is configured to, and, when the test system (**200**) is interfaced to the electronic memory device (**105**) to be tested, is operable to keep one or more second electrically conductive column lines (**C₁₋₂, C₂₋₂**, **..., Cₘ₋₂**) of the electronic memory device (**105**) to be tested electrically disconnected, or to electrically connect one or more second electrically conductive column lines (**C₁₋₂, C₂₋₂**, **..., Cₘ₋₂**) of the electronic memory device (**105**) to be tested to electrical quantities measuring devices (**240**), or to route, selectively and independently to each second electrically conductive column line (**C₁₋₂, C₂₋₂**, **..., Cₘ₋₂**) of the electronic memory device (**105**) to be tested, an electrical signal selected from:
o a second column electric potential waveform (**505**), common to all the second electrically conductive column lines (**C₁₋₂, C₂₋₂**, **..., Cₘ₋₂**) of the electronic memory device (**105**) to be tested;
o the common reference electrical potential (**GND**).

3. Test system (**200**) according to claim 1 or 2, comprising one or more electrical quantities waveform generators (**210**), configured and operable to generate said row electric potential waveform (**605**), said first column electric potential waveform (**405**) and said second column electric potential waveform (**505**).

4. Test system (**200**) according to any of the preceding claims, comprising reference electrical potential generators (**230**), configured and operable to generate said row reference electrical potential (**Vr₁, Vr₂, ..., Vrₙ**) independently for each electrically conductive row line (**R₁, R₂, ..., Rₙ**)**.**

5. Test system (**200**) according to any of the preceding claims, wherein said electrical quantities measuring devices (**240**) comprise one or more current sensors, configured and operable to detect a current flowing in one or more of said second electrically conductive column lines (**C₁₋₂, C₂₋₂**, **..., Cₘ₋₂**) of the electronic memory device (**105**) to be tested which, through the second column multiplexer (**315**), is/are connected to the electrical quantities measuring devices (**240**).

6. Test system (**200**) according to any of the preceding claims, wherein:
- the row multiplexer (**305**) comprises a number of row multiplexer devices (**MUX_{R1}, MUX_{R2}, ..., MUX_{Rn}**) equal to the number of electrically conductive row lines (**R₁, R₂, ..., Rₙ**) of the electronic memory device (**105**) to be tested, the row multiplexer devices (**MUX_{R1}**, **MUX_{R2}, ..., MUX_{Rn}**) each being interfaceable to a respective electrically conductive row line (**R₁, R₂, ..., Rₙ**);
- the first column multiplexer (**310**) comprises a number of first column multiplexer devices **(MUX₁₋₁**, **MUX₂₋₁, ..., MUXₘ₋₁**) equal to the number of first electrically conductive column lines (**C₁₋₁, C₂₋₁, ..., Cₘ₋₁**) of the electronic memory device (**105**) to be tested, the first column multiplexer devices (**MUX₁₋₁**, **MUX₂₋₁, ..., MUXₘ₋₁**) being each interfaceable to a respective first electrically conductive column line (**C₁₋₁, C₂₋₁,** ..., **Cₘ₋₁**) of the electronic memory device (**105**) to be tested, and
- the second column multiplexer (**315**) comprises a number of second column multiplexer devices (**MUX₁₋₂, MUX₂₋₂, ..., MUXₘ₋₂**) equal to the number of second electrically conductive column lines (**C₁₋₂, C₂₋₂**, **..., Cₘ₋₂** ) of the electronic memory device (**105**) to be tested, the second column multiplexer devices (**C₁₋₂, C₂₋₂**, **..., Cₘ₋₂**) being each interfaceable to a respective second electrically conductive column line (**C₁₋₂, C₂₋₂**, **..., Cₘ₋₂**) of the electronic memory device (**105**) to be tested.

7. Test system (**200**) according to any of the preceding claims, configured to interface with and test an electronic memory device (**105**) of the neuromorphic type.

8. Test system ( **200** ) according to any of the preceding claims, configured and operable to perform, on said electronic memory device (**105**) to be tested:
- writing operations of single memory cells (**110**) of the electronic memory device (**105**) to be tested;
- reading operations of single memory cells (**110**) of the electronic memory device (**105**) to be tested;
- memory cell aging simulation operations (**110**);
- emulation operations of computation operations, particularly matrix product operations, which the electronic memory device (**105**) is intended to perform in use.

9. Test system (**200**) according to any of the preceding claims, wherein: the row multiplexer (**305**) of the test system is configured to interface with all the electrically conductive row lines (**R₁, R₂,** ..., **Rₙ**) of the electronic memory device (**105**) to be tested; the first column multiplexer (**310**) of the test system (**200**) is configured to interface with all the first electrically conductive column lines (**C₁₋₁, C₂₋₁, ..., Cₘ₋₁**) of the electronic memory device (**105**) to be tested, and the second column multiplexer (**315**) of the test system (**200**) is configured to interface with all the second electrically conductive column lines (**C₁₋₂, C₂₋₂**, ..., **Cₘ₋₂**) of the electronic memory device to be tested.
